# EUROPEAN PATENT APPLICATION

(11) **EP 4 187 589 A1**
(43) Date of publication of application: **31.05.2023**
(21) Application number: 21210286.7
(22) Date of filing: 24.11.2021
(51) Int. Cl.: H01L 23/29, H01L 23/373

(54) **DIRECTLY COOLED POWER MODULE**

(71) Applicant: SwissSEM Technologies AG, 5600 Lenzburg (CH)
(72) Inventor: Schnell, Raffael, CH-5703 Seon (CH)
(74) Representative: Felber, Josef

(57) **Abstract**

The Power module incorporates a cooling structure (9) directly applied to the lower metallization (5) of the integrated substrate (4) by either welding, ribbon bonding, soldering or sintering. In a preferred embodiment, it is equipped with a glass fiber reinforced plastic encapsulation (13) molded to the integrated substrate (4) to mechanically support the integrated substrate (6) against pressure peaks from the cooling media and to protect the IGBT/Diode MOSFET chips (1) from environmental impact like humidity and foreign materials.

## Description

Power modules in the kilo watt range or above are applied in millions of units each year in industrial applications or electric vehicles. Such modules are built into inverters for electric vehicles, drives for industrial applications like elevators, fan-controllers etc. The modules must efficiently switch the electric current on and off several 1000 times a second and this with an expected lifetime of 10 to 30 years. The highly efficient production of these modules is demanding, and the thermal and electrical properties and the reliability levels requested by the customers are high. An efficient cooling and minimized numbers of mechanical interfaces (solder, sinter or welding joints) are key factors for high reliability and lifetime. Presently approx. 10 million units of such Power Modules are being manufactured annually.

A typical power module comprises a baseplate, attached thereto integrated substrates with an insulation layer and a conducting upper-side metal sheet with attached chips (e.g. IGBTs, diodes, MOSFETs etc.) and wire-bonds for the electrical connections, power- and signal terminals for external busbar attachments and external controlling. The power terminals for high-currents beyond 100 A and the signal pins are either soldered, welded, or connected by multiple parallel bonded wires to the top-substrate metallization. The dielectric insulation and protection against environmental impact is usually done with a soft silicone gel and a plastic housing or molding with an epoxy or similar compound. For modules with direct cooling the baseplate has a cooling structure which can be pin-fins or welded-on metal ribbons to improve the heat transfer to the cooling medium.

The main problem of typical power modules is the ageing of the solder or sinter interface between the substrate and the baseplate. Especially in traction applications of electric vehicles (EV) like trains, busses or cars, the power module is suspected to strong temperature cycles during acceleration and deceleration many times a day which can cumulate in many millions of cycles during a lifetime. The used materials in a power modules like chips, substrate and baseplate have different coefficients of thermal expansion (CTE) which causes stress to the solder or sinter joining layers during temperature cycles and finally this leads to delamination of the layers and device failure. The substrate CTE can be adjusted either to the Chip or baseplate by selecting appropriate insulating materials. In most cases, the CTE mismatch to the baseplate (Copper, Aluminum or AlSiC) remains significant, and due to the large solder/sinter joint area the stress is high and this is the usual life-time limiting weak spot in the power module design.

The object of this invention is it to improve such power modules by reducing or even eliminating the problem of the effect of the different coefficients of thermal expansion (CTE) of the different materials used in such power modules like chips, substrate and baseplate which causes stress to the solder or sinter joining layers during temperature cycles, and to avoid an ultimate delamination of the layers and device failure.

This object is attained by a power module with direct cooling and without baseplate. The metal cooling structure is directly applied to the lower substrate metallization. By this way, the weak large area, that is the solder/sinter joint area between substrate and baseplate is eliminated.

In the figures, conventional power modules are shown, and one embodiment of an advanced power module according to the present invention is shown as an example and it will be explained in detail in the following description and its advantages will be explained.

The figures show:
- Figure 1:: An example of a state of the art power module in isometric view;
- Figure 2:: A cross-sectional view through a typical state of the art power module with direct cooling using a pin-fin cooling structure;
- Figure 3:: A cross-sectional view through a typical state of the art power module with direct cooling using a ribbon-bond cooling structure;
- Figure 4:: A cross-sectional view through the newly invented power module with direct cooling using a ribbon-bond cooling structure omitting the baseplate and large area solder/sinter attach;
- Figure 5:: The invented power module in isometric view;
- Figure 6:: The invented power module with reinforced molded encapsulation.

In order to reinforce the relatively thin integrated substrate against pressure peaks from the cooling media, such modules can be encapsulated with a rigid glass fiber reinforced mold compound.

The cooling structure can be applied at the end of the module manufacturing and testing process for example by welding/ribbon bonding, hence the cooling structure is only applied to good modules (cost advantage) and can be tailored to application needs like different cooling medias. In addition, the process costs of attaching the baseplate and the material costs of the baseplate are saved.

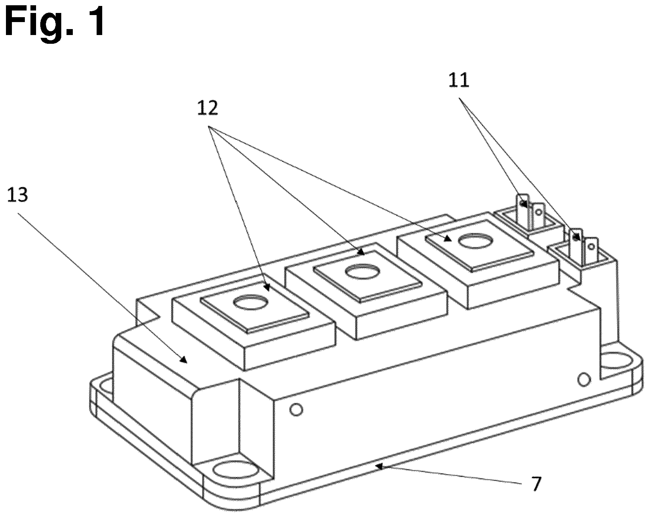

A typical power module of 62 mm width according to the state of the art is shown in a perspective view in **Figure 1****.** With its baseplate 7, housing 13 on top of the baseplate 7 and the electrical connections 12 on its top and the signal terminals 11. The dimensions of the shown module base plate are about 62 mm x 106 mm.

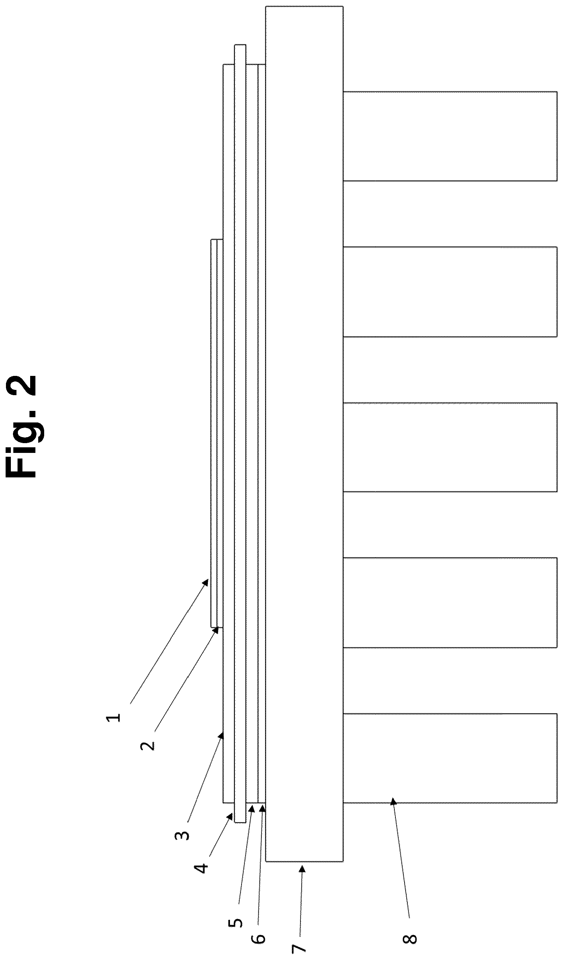

A typical power module stack according to the state of the art is shown in a generic cross-section in **Figure 2****.** It comprises IGBT/Diode or MOSFET chips 1 attached with a solder or sinter layer 2 to the integrated substrate consisting of an upper metallization 3 and electrical insulator 4 and a lower metallization 5. The substrate is attached with a substrate solder or sinter layer 6 to the baseplate 7 with an integrated pin-fin or similar cooling structure 8.

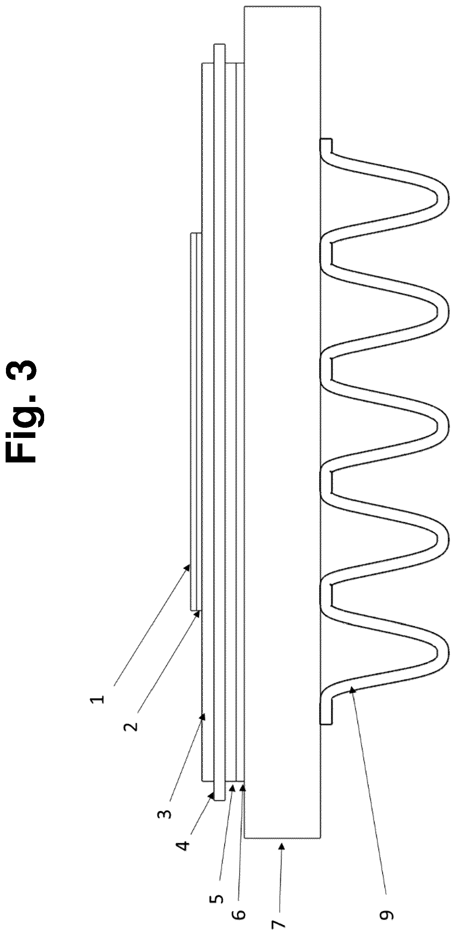

A typical power module stack according to the state of the art is shown in a generic cross-section in **Figure 3****.** It comprises IGBT/Diode or MOSFET chips 1 attached with a solder or sinter layer 2 to the integrated substrate consisting of an upper metallization 3 and electrical insulator 4 and a lower metallization 5. The substrate is attached with a substrate solder or sinter layer 6 to the baseplate 7. To the baseplate, a cooling structure 9 is attached by welding or a similar process.

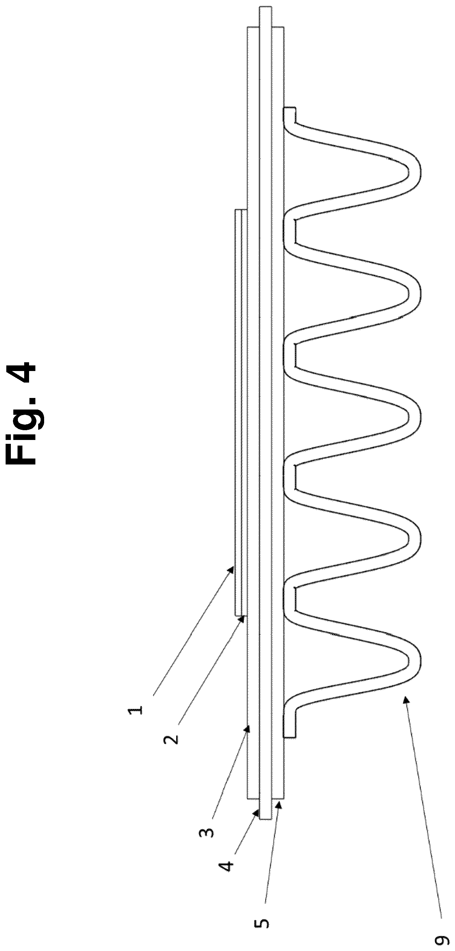

**Figure 4** shows a cross section of a power module according to the present invention. It comprises IGBT/Diode or MOSFET chips 1 attached with a solder or sinter layer 2 to the integrated substrate consisting of an upper metallization 3 and electrical insulator 4 and a lower metallization 5. The cooling structure 9 is directly attached to the lower metallization 5 of the integrated substrate, rendering the weak substrate solder or sinter layer 6 and the baseplate 7 obsolete. The cooling structure can be applied by welding, soldering, sintering or ribbon bonding.

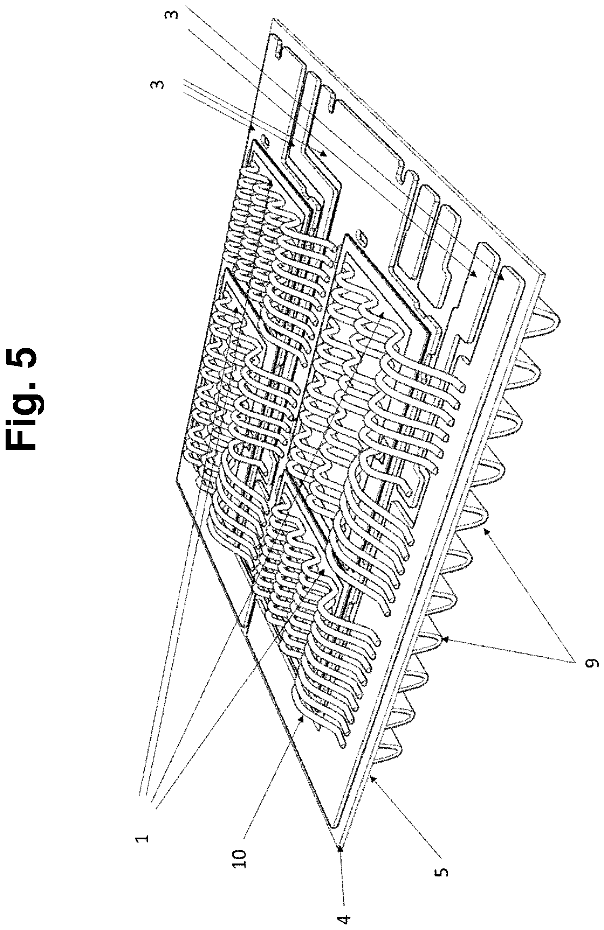

**Figure 5** shows the interior of a power module according to the present invention in isometric view. The IGBT/Diode or MOSFET 1 chips are electrically connected with bond-wires 10 and attached via a solder or sinter layer to the upper metallization 3 which also connects external contacts. The insulating layer 4 electrically insulates the conducting part from the cooling media whilst having still good thermal conductivity. It can be made from a good thermally conducting insulator like Al2O3, Si3N4 or dedicated mold compounds. Below the insulation layer 4 follows the metallization layer 5 which is not visible in this view, and the cooling structure 9 is directly attached to this metallization layer 5.

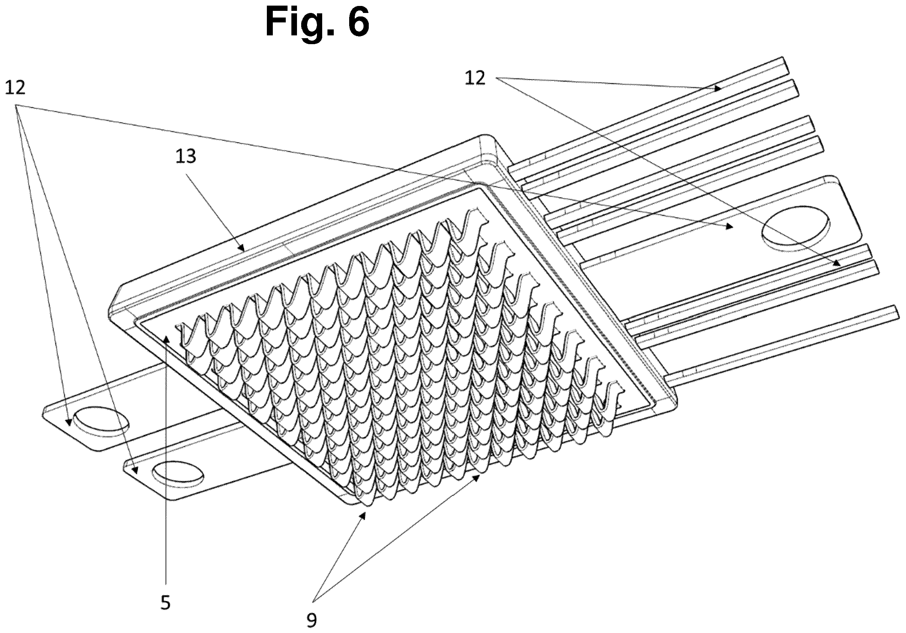

A complete assembled module according to the present invitation is shown in **Figure 6****.** It compromises external electrical contacts 12 and signal terminals internally attached to the upper metallization for example by soldering, welding, or sintering. The cooling structure 9 can be joined to the baseplate after the complete module assembly by welding, ribbon bonding, soldering, or sintering. The module encapsulation 13 is made of a glass fiber reinforced plastic compound and can be realized with a molding process. A typical size of such encapsulation 13 (or entire module?) is about 50 mm x 90 mm.

### List of Numerals

- 1: Chip
- 2: Chip solder / sinter layer
- 3: Upper side metallization (integrated Substrate)
- 4: Insulator (integrated Substrate)
- 5: Lower side metallization (integrated Substrate)
- 6: Substrate solder / sinter layer
- 7: Metal baseplate
- 8: Pin-fin cooling element integrated in baseplate
- 9: Cooling structure welded to baseplate or lower metallization
- 10: Bond-wires
- 11: Signal terminals
- 12: Electrical connections
- 13: Module encapsulation/housing

## Claims

1. Power module with a cooling structure (9) directly applied to the lower metallization (5) of the integrated substrate (4) by either welding, ribbon bonding, soldering or sintering.

2. Power module according to claim 1 with a glass fiber reinforced plastic encapsulation (13) molded to the integrated substrate (4) to mechanically support the integrated substrate (4) against pressure peaks from the cooling media and to protect the IGBT/Diode MOSFET chips (1) from environmental impact like humidity and foreign materials.
